# EUROPÄISCHE PATENTANMELDUNG

(11) **EP 4 679 080 A1**
(43) Veröffentlichungstag der Anmeldung: **14.01.2026**
(21) Anmeldenummer: 25187691.8
(22) Anmeldetag: 05.07.2025
(51) Int. Cl.: G01N 27/90, G01N 27/02

(54) **MESSVORRICHTUNG ZUR CHARAKTERISIERUNG EINES MESSOBJEKTES IM VAKUUM MITTELS INDUKTIVEM SENSOR IN ELEKTROMAGNETISCHER TRANSMISSION**

(30) Priorität: 09.07.2024 DE 102024119448
(71) Anmelder: SURAGUS GmbH, 01109 Dresden (DE)
(72) Erfinder: Klein, Marcus, 01109 Dresden (DE); Koch, Florian, 01109 Dresden (DE)
(74) Vertreter: Querner, Yvonne Anne

(57) **Zusammenfassung**

Die Erfindung betrifft eine Messvorrichtung zur Charakterisierung eines Messobjektes im Vakuum, wobei die Messvorrichtung mindestens einen induktiven Sensor umfasst, der mindestens eine Sendespule zum Erzeugen eines elektromagnetischen Wechselfeldes und eine Empfangsspule zum Erfassen einer Impedanzänderung sowie einen Signalverstärker und/oder eine Signalverarbeitungseinheit zur Auswertung der Messsignale aufweist. Die Aufgabe der vorliegenden Erfindung eine Messvorrichtung anzugeben, die mit minimalem zusätzlichen Platzaufwand innerhalb des Vakuum in einer Vakuumanlage integriert werden kann und eine Messung mit hoher Genauigkeit und hoher Ortsauflösung bei präziser Wiederholbarkeit auf einem statischen und/oder an der Messvorrichtung vorbeigeführten Messobjekt ermöglicht, wird dadurch gelöst, dass sowohl die Sende- und Empfangsspule als auch der Signalverstärker und/oder die Signalverarbeitungseinheit außerhalb eines Vakuumbereichs angeordnet sind, wobei die Sende- und Empfangsspule jeweils in eine Kapsel einführbar sind und die Kapseln als ein integraler Bestandteil einer Kammerwand einer Vakuumkammer ausgebildet ist und in das Vakuum hineinragt, wobei die Kammerwand den Vakuumbereich von einer Atmosphärenseite trennt.

## Beschreibung

Die Erfindung betrifft eine Messvorrichtung zur Charakterisierung eines Messobjektes im Vakuum, wobei die Messvorrichtung mindestens einen induktiven Sensor umfasst, der mindestens eine Sendespule zum Erzeugen eines elektromagnetischen Wechselfeldes und eine Empfangsspule zum Erfassen einer Impedanzänderung sowie einen Signalverstärker und/oder eine Signalverarbeitungseinheit zur Auswertung der Messsignale aufweist.

Zu den induktiven Sensoren gehören die Wirbelstromsensoren. Die Wirbelstromsensoren sind induktiv wirkende Sensoren, die sowohl berührend als auch berührungslos einsetzbar sind. Ihr Messprinzip basiert darauf, dass eine Sende- bzw. Induktionsspule in einem Sensorkopf des Wirbelstromsensors mit einem Wechselstrom beaufschlagt wird und somit ein elektromagnetisches Wechselfeld bzw. Primärfeld erzeugt wird. Das Primärfeld induziert in einem zu charakterisierenden Messobjekt Wirbelströme. Der im Messobjekt fließende Wirbelstrom erzeugt ein elektromagnetisches Sekundärfeld, welches dem von der Spule erzeugten Primärfeld entgegengerichtet ist und somit das von dem Primärfeld und dem Sekundärfeld gebildete Gesamtfeld beeinflusst. Die Änderung des Gesamtfeldes kann mittels induktiver Sensoren, z. B. einer Spule erfasst werden. Die Feldänderungen sind z. B. abhängig von dem Material sowie von der Position des Messobjekts im Gesamtfeld bzw. von dem Volumen des Materials des Messobjekts. Die Feldänderungen werden genutzt, um Rückschlüsse hinsichtlich der Materialeigenschaften und/oder des Volumens und/oder der Position des Messobjekts zu ziehen.

Wirbelstromsensoren können in unterschiedlichen Spulenanordnungen bzw. Geometrien vorgesehen sein, z. B. in Transmissionsgeometrie, wobei das zu charakterisierende Messobjekt zwischen einer Sende- und einer Empfangsspule angeordnet ist, oder in Reflexionsgeometrie oder Halbtransmissionsgeometrie, wobei Sende- und Empfangsspule auf derselben Seite des Messobjekts angeordnet sind. Bei Verwendung der Reflexionsgeometrie können die Sendespule und die Empfangsspule separat voneinander vorgesehen sein oder integral miteinander ausgebildet sein. Auch ist die Verwendung als Absolutspule möglich, das bedeutet, dass eine einzige Spule sowohl als Sendespule als auch als Empfangsspule fungiert. Alle Sensoren, die in Reflexion arbeiten sind gewöhnlich sehr abstandssensitiv und werden oft als Präsenzsensoren oder Abstandssensoren eingesetzt.

Wirbelstromsensoren werden für die Schichtcharakterisierung in verschiedenen Industrien eingesetzt, so auch in der Halbleiterindustrie. Diese Sensoren bestehen aus mindestens einer Spule sowie einer spulennahen Elektronik für die Signalverstärkung. Es sind Systeme für die Vermessung von Schichten außerhalb von Vakuumkammern als Tischsysteme oder auch freistehende Systeme bekannt. Auch sind Messungen im Vakuum in großen Glas- und Folienbeschichtungsanlagen bekannt. Hierbei wird ein oder werden mehrere Sensoren samt einer Vorverstärkerelektronik ins Vakuum integriert. Aufgrund des Platzbedarfes handelt es sich hierbei bisher immer um recht große Vakuumkammern, welche ausreichend Platz für die Sensorik bieten. Die Einsatzmöglichkeiten in (Hoch-) Vakuum-Clustertools sind begrenzt, da keine der bisher bekannten Lösungen die Anforderungen an Platz, Temperatur und (Hoch-)Vakuum erfüllt. Vielmehr basiert der gegenwärtige Stand der Technik bezüglich Schichtcharakterisierungskonzepten in der Halbleiterindustrie auf Ex-situ-Messungen mittels kontaktierender Vierspitzenmessungen, die erst Stunden oder Tage nach dem Beschichtungsprozess durchgeführt werden. Diese Technologie erfordert eine umfangreiche Logistik für sogenannte Testwafer, die als Referenz-Wafer für den zu charakterisierenden Prozess, d. h. die zu charakterisierenden Produkt-Wafer dienen und die nach der Messung entweder entsorgt oder aufwendig recycelt, z. B. zurückgeätzt, werden müssen. Der Einsatz von Testwafern hat einige Nachteile. Beispielsweise geht Anlagenkapazität verloren, wenn Testwafer prozessiert werden, Prozessfehler werden erst nach Stunden oder Tagen bekannt und es gibt keine 100%ige Kontrolle über den Prozess, da nur stichprobenartige Messungen möglich sind. Ein weiterer Nachteil ist, dass davon ausgegangen wird, dass die Testwafer repräsentativ für Produktwafer sind, jedoch verhalten sich Testwafer häufig anders als Produktwafer, da sie oft unterschiedliche thermische Massen aufweisen und Warpage-Effekte das Prozessergebnis beeinflussen. Unter Warpage wird die Verformung oder Krümmung des Wafer-Substrats verstanden, das bedeutet, dass der Wafer nicht mehr flach ist, sondern sich in eine bestimmte Richtung wölbt oder biegt.

(Hoch- und Ultrahoch-)Vakuum-Prozessierungsanlagen vermeiden die Integration von Elektronik im Vakuum, um Verunreinigungen und Ausgasung vorzubeugen. Zudem sind Vakuumkammern volumenoptimiert und daher sehr kompakt gebaut, um die langen Abpumpzeiten zu minimieren. Wirbelstromsensoren zur Vermessung von nanometerdünnen Schichten stellen erhebliche technische Anforderungen an den Messaufbau. Beispielsweise ist eine komplexe Signalverarbeitung erforderlich, verbunden mit einer hohen Rechenleistung, die erhebliche Wärme erzeugt. Im Vakuum ist die Wärmeabfuhr im Vergleich zu Messaufbauten bei Atmosphärendruck eingeschränkt, da die Wärme nur über Strahlung abtransportiert werden kann. Daher verfälschen thermische Driften die Messergebnisse. Optimalerweise wird deshalb die gesamte Messtechnik außerhalb des Vakuums positioniert. So messen beispielsweise optische Sensoren durch Glasfenster. Der Einsatz optischer Sensoren für die Schichtcharakterisierung ist jedoch auf optisch transparente Schichten begrenzt. Für die Vermessung von intransparenten Metallschichten innerhalb einer Anlage bleibt derzeit nur die Verwendung der zuvor genannten Testwafer, welche außerhalb der Beschichtungskammer und außerhalb des Vakuums charakterisiert werden. Für Verdampfer-Anlagen (evaporation) werden üblicherweise Schwingquarze für die Schichtdickenmessung beschichtet. Dies ist eine indirekte Methode, welche an einem Referenzort mit anderen Beschichtungsraten stattfindet und diverse Nachteile aufweist. Neben der Notwendigkeit Korrekturfaktoren zu nutzen, muss der Schwingquarz ausgetauscht oder gereinigt werden. Zudem ist das Verfahren nur nutzbar, wenn der Schwingquarz vergleichbar mitbeschichtet werden kann, ohne einen Schatten auf dem Substrat zu hinterlassen. Dies ist in Clusteranlagen, welche Metallschichten abscheiden, überwiegend nicht der Fall.

Daher werden bisher keine Wirbelstromsensoren für die Material- bzw. Schichtcharakterisierung in (Hoch-) Vakuum-Clustertoolprozesskammern der Halbleiterindustrie eingesetzt. Zu den oben genannten Gründen gibt es auch viele Integrationsprobleme in bestehende Anlagen. So sind beispielsweise vorhandene Anordnungen von Durchführungen in Vakuumkammern für die Integration von Messtechnik oft ungeeignet, in kompakten Vakuumkammern ist kein Platz für zusätzliche Messtechnik, so dass es keine flexiblen Positionierungsmöglichkeiten gibt.

Eine direkte Schichtwiderstandsmessung oder Metalldickenmessung in einer Vakuumkammer wäre sehr vorteilhaft, jedoch ist es mit bekannten Wirbelstromsensoren nicht möglich, ausreichend Raum für das Vorbeibewegen von Prüfgütern zu schaffen, da der Arbeitsabstand nur einige Hundert Mikrometer bis wenige Millimeter beträgt. In einer Produktionsumgebung ist dies nicht praktikabel, da beispielsweise Vibrationen, Bewegungen und Schwingungen eines Waferhandlers zu Kollisionen führen können. Kleinste Positionsabweichungen führen zu Messfehlern. Moderne Waferhandling-Module transportieren zwei Wafer gleichzeitig übereinander (zwei-etagig), damit ist eine Messung mit konventionellen Sensoren konstruktiv unmöglich. In der EP 0 337 253 A2 ist eine Vorrichtung zur Messung der Leitfähigkeit von Materialien beschrieben. Die Messung erfolgt im Vakuum und das zu charakterisierende Messobjekt wird in einem Abstand von 2mm bis 5mm zwischen den Messspulen positioniert, da die Messspulen keinen größeren Arbeitsabstand bieten. Benötigt werden daher Sensoren mit einem großen Arbeitsabstand und einer möglichst großen Abstandstoleranz.

Eine weitere Herausforderung ist, dass beispielsweise gesputterte Schichten oft heiß sind und diese die temperatursensitiven Wirbelstromsensoren erwärmen würden, was einen sehr negativen Einfluss auf die Messgenauigkeit und auch Vergleichbarkeit von Messergebnissen hat, wie zuvor beschrieben. Eine Messung in einem großen Abstand von mehr als 5 mm bis 10 mm oder gar 50 **mm,** abhängig von den Anlagengegebenheiten, vermindert stark die im Vakuum wirkende Wärmestrahlung und damit die Erwärmung des Sensors. Dadurch würde eine höhere Messgenauigkeit erreicht werden und ist daher wünschenswert. Sensoren, die abstandstolerant sind und bei großen Anständen, bevorzugt mehr als 10mm bis 50mm präzise messen können, sind bisher nicht bekannt.

Es ist daher die Aufgabe der vorliegenden Erfindung eine Messvorrichtung anzugeben, die mit minimalem zusätzlichen Platzaufwand, ohne oder nahezu ohne Ausgasung in einer (Hoch-)Vakuumanlage in einer definierten Lage und mit einer definierten Abstandstoleranz zum Prüfgut integriert werden kann und somit eine Messung mit hoher Widerholbarkeit und Genauigkeit auf einem statischen und/oder an der Messvorrichtung vorbeigeführten Messobjekt ermöglicht.

Die Aufgabe der vorliegenden Erfindung wird durch die Messvorrichtung gemäß dem unabhängigen Anspruch 1 gelöst.

Die Messvorrichtung zur Charakterisierung eines Messobjektes im Vakuum umfasst mindestens einen induktiven Sensor, der mindestens eine Sendespule zum Erzeugen eines elektromagnetischen Wechselfeldes und eine Empfangsspule zum Erfassen einer Impedanzänderung sowie einen Signalverstärker und/oder eine Signalverarbeitungseinheit zur Auswertung der Messsignale aufweist. Erfindungsgemäß sind sowohl die Sende- und Empfangsspule als auch der Signalverstärker und/oder die Signalverarbeitungseinheit außerhalb eines Vakuumbereichs angeordnet, wobei die Sende- und Empfangsspule jeweils in eine Kapsel einführbar sind und die Kapsel jeweils als ein integraler Bestandteil einer Kammerwand einer Vakuumkammer ausgebildet ist und in das Vakuum hineinragt, wobei die Kammerwand den Vakuumbereich von einer Atmosphärenseite trennt. Die Kapsel ist Bestandteil der erfindungsgemäßen Messeinrichtung.

Der Vorteil dieses zweigeteilten Aufbaus der Messvorrichtung ist darin zu sehen, dass durch die in der Kammerwand integriert angeordneten Kapseln, die komplette Messeinrichtung umfassend die Sende- und Empfangsspule eines induktiven Sensors, insbesondere eines Wirbelstromsensors sowie die gesamte Signalverarbeitung außerhalb des Vakuums positioniert ist. Durch die in das Vakuum hineinragenden Kapseln, eine für die Sendespule und eine für die Empfangsspule, können die Spulen nahe zum Messort geführt werden. Das elektromagnetische Feld des Wirbelstromsensors wirkt direkt durch die Kapseln hindurch und ermöglicht so eine Messung bei vollständiger Anordnung der Komponenten der Messeinrichtung außerhalb des Vakuums. Dies unterstützt die Reinheit von (Ultrahoch-)Vakuumprozessen. Auch erlaubt es, den Sensor auszutauschen, ohne das Vakuum unterbrechen zu müssen.

Des Weiteren wird dadurch vermieden, wärmeerzeugende Komponenten, wie den Signalverstärker und/oder die Signalverarbeitungseinheit oder potenziell ausgasende Teile in das Vakuum zu bringen und gleichzeitig Platz in der Vakuumkammer einzusparen. Durch eine geeignete Signalverarbeitung, u. a. mittels Filter, FPGAs, können Störeinflüsse, die aufgrund des baulich bedingten Abstandes zwischen den Sensorspulen und der Signalverarbeitung auftreten, herausgerechnet/korrigiert werden.

Die Aufgabe wird auch durch eine Messvorrichtung gemäß dem unabhängigen Anspruch 2 gelöst.

Die Messvorrichtung zur Charakterisierung eines Messobjektes im Vakuum umfasst mindestens einen induktiven Sensor, der mindestens eine Sendespule zum Erzeugen eines elektromagnetischen Wechselfeldes und eine Empfangsspule zum Erfassen einer Impedanzänderung sowie einen Signalverstärker und/oder eine Signalverarbeitungseinheit zur Auswertung der Messsignale aufweist. Erfindungsgemäß sind die Sende- und Empfangsspule jeweils von einem vakuumtauglichen Material umhüllt ausgebildet und innerhalb des Vakuumbereichs angeordnet und der Signalverstärker und/oder die Signalverarbeitungseinheit sind außerhalb eines Vakuumbereichs angeordnet, wobei die umhüllte Sende- und Empfangsspule jeweils über einen Flansch oder eine Dichtung über eine Kammerwand einer Vakuumkammer mit dem Signalverstärker und/oder der Signalverarbeitungseinheit auf einer Atmosphärenseite verbunden sind, wobei die Sende- und Empfangsspule einen räumlichen Abstand von 10mm, bevorzugt von bis zu 100mm zueinander aufweisen. Die Kammerwand trennt die Vakuumkammer von der Atmosphärenseite.

Die Sende- und Empfangsspule sind jeweils von einem vakuumtauglichen Material umhüllt ausgebildet und bilden einen Sensorkopf, der sich innerhalb des Vakuums befindet. Ein vakuumtaugliches Material ist ein Material, welches in keiner bzw. nahezu keiner Wechselwirkung mit dem Vakuum steht oder Einfluss auf das Vakuum im Inneren der Vakuumkammer nimmt. Über einen Flansch oder eine Dichtung ist der Sensorkopf in der Kammerwand einer Vakuumkammer vakuumdicht integriert, so dass außerhalb der Vakuumkammer der Signalverstärker und/oder die Signalverarbeitungseinheit an den Sensorkopf anschließbar sind. Der Vorteil ist, dass auch bei dieser Lösung vermieden wird, wärmeerzeugende bzw. temperaturempfindliche Komponenten, wie den Signalverstärker und/oder die Signalverarbeitungseinheit oder potenziell ausgasende Teile in das Vakuum zu bringen und gleichzeitig Platz in der Vakuumkammer eingespart werden kann. Durch eine geeignete Signalverarbeitung, u. a. mittels Filter, FPGAs, können Störeinflüsse, die aufgrund des baulich bedingten Abstandes zwischen den Sensorspulen/dem Sensorkopf und der Signalverarbeitung auftreten, herausgerechnet/korrigiert werden.

In einer Ausgestaltung der erfindungsgemäßen Messvorrichtungen ist der induktive Sensor in einer Transmissionsgeometrie ausgebildet, wobei die Sendespule oberhalb und die Empfangsspule unterhalb des zu messenden Messobjektes oder umgekehrt ausgebildet ist. Es ist auch möglich, dass ober- und unterhalb des zu messenden Messobjektes Sensorelemente angeordnet sind, die sowohl als Sendespule als auch Empfangsspule ausgebildet sind.

Der Vorteil der Anordnung in Transmissionsgeometrie ist, dass große Abstände zum Messobjekt bis zu 50 mm ermöglicht werden. Die Abstandsangabe ist in der Regel die halbe Entfernung zwischen der Sende- und Empfangsspule, also den zwei Sensorköpfen, -spitzen. Gleichzeitig steigt die Positionierungstoleranz mit der Größe des Abstandes. Der Transmissionsansatz eignet sich daher besonders gut, wenn große Abstände sinnvoll oder erforderlich sind. Dies kann der Fall sein bei heißen Messobjekten oder beim Vorliegen eines hohen Automatisierungsgrads. Bei der Transmissionsgeometrie sind die Sende- und Empfangsspule getrennt voneinander und sich gegenüberliegend angeordnet ausgebildet und jeweils für sich entweder in eine in der Kammerwand integrierten Kapsel einführbar oder jeweils für sich mit einem vakuumtauglichen Material umhüllt in der Vakuumkammer jeweils über eine Dichtung oder einen Flansch mit der Atmosphärenseite elektrisch mit dem Signalverstärker und der Signalverarbeitungseinheit verbunden ausgebildet.

In einer anderen Ausgestaltung der erfindungsgemäßen Messvorrichtungen ist das zu messende Messobjekt berührungslos vermessbar, wobei der induktive Sensor das Messobjekt in elektromagnetischer Transmission während einer Bewegung des zu messenden Messobjekts an dem induktiven Sensor vorbei und/oder statisch auf dem Messobjekt vermisst.

Das in der Sende- bzw. Primärspule erzeugte elektromagnetische Wechselfeld bzw. Primärfeld induziert in dem zu charakterisierenden Messobjekt Wirbelströme. Diese rufen ein elektromagnetisches Sekundärfeld hervor, welches dem von der Spule erzeugten Primärfeld entgegengerichtet ist und somit das von dem Primärfeld und dem Sekundärfeld gebildete Gesamtfeld beeinflusst. Dies ist sowohl in einem vorbeibewegten Messobjekt erfassbar als auch statisch an einem Messobjekt detektierbar. Durch die von der Signalverarbeitungseinheit erfasste Impedanz bzw. Impedanzänderung der Empfangs- bzw. Messspule können entweder Rückschlüsse auf elektrische oder mechanische bzw. geometrische Eigenschaften des zu untersuchenden Messobjektes gezogen werden. Für die elektrische Charakterisierung einer beispielsweise abgeschiedenen Schicht auf einem zu untersuchenden Messobjekt, kann aus den Messignalen der Schichtwiderstand bestimmt werden. Für eine mechanische Charakterisierung einer beispielsweise abgeschiedenen Schicht auf einem zu untersuchenden Messobjekt, kann die Schichtdicke des Messobjekts aus den Messignalen bestimmt werden.

In einer weiteren Ausgestaltung der erfindungsgemäßen Messvorrichtungen ist das zu charakterisierendes Messobjekt in einem Abstand von 5 bis 25 mm, bevorzugt bis 50 mm an den Kapseln oder der umhüllten Sende- und Empfangsspule vorbeiführbar. Damit ist genügend Raum für das Vorbeibewegen des zu charakterisierenden Messobjekts realisiert. Gleichzeitig steigt die Positionierungstoleranz mit der Größe des Abstandes. Große Abstände sind vor allem bei heißen Messobjekten oder beim Vorliegen eines hohen Automatisierungsgrads erforderlich und ermöglichen erst die Messung.

In einer weiteren anderen Ausgestaltung der erfindungsgemäßen Messvorrichtungen sind die in den Vakuumbereich hineinragenden Kapseln gemäß der ersten Erfindungsvariante aus einem nichtleitfähigen und nicht ausgasenden Material ausgebildet oder die Sende- und Empfangsspule sind mit einem nichtleitfähigen und nicht ausgasenden Material gekapselt gemäß einer zweiten Erfindungsvariante ausgebildet. Dies unterstützt weiter die Reinheit von (Ultrahoch-)Vakuumprozessen. Derartige Materialien können beispielsweise PEEK (Polyetheretherketon) und andere wenig ausgasende Kunststoffe sein. Die Kapsel muss mindestens an den Spitzen nichtleitfähig sein, da sonst keine Messung durch die Kapsel möglich ist.

In einer Ausgestaltung der erfindungsgemäßen Messvorrichtungen ist die Messvorrichtung in einer separaten Messkammer angeordnet, welche an eine Prozesskammer oder Handlingkammer, in der das zu messende Messobjekt prozessierbar ist, entweder in einer ersten Erfindungsvariante über die Kapseln als Teil der Messvorrichtung oder in einer zweiten Erfindungsvariante über einen Flansch oder eine Dichtung anschließbar und das zu messende Messobjekt ist über ein Handlingsystem von der Prozess- oder Handlingkammer in die Messkammer ohne Vakuumunterbrechung transferierbar und dort vermessbar.

Der Vorteil dieser Ausgestaltung ist, dass die Messkammer individuell, einfach und ohne großen Aufwand an eine freie Position einer Prozessanlage anschließbar ist. Viele Anschlüsse an Prozessanlagen sind standardisiert. Teils sind auch nicht alle Positionen an einer Prozessanlage belegt. Damit ist die Messkammer als separates Modul je nach Prozess sehr leicht zu integrieren. Gleichzeitig bietet sie dieselben Vorteile wie die Anordnung direkt in der Prozesskammer, wie weiter oben beschrieben wurde.

In einer anderen Ausgestaltung der erfindungsgemäßen Messvorrichtungen ist die Messvorrichtung in einem 5 bis 75 mm dicken, vorzugsweise 15 mm dicken Zwischenmodul, welches zwischen der Prozesskammer und einem Handlingbereich angeordnet ist, ausgebildet, wobei das Zwischenmodul als ein 220 mm bis 4500 mm breiter Rahmen ausgebildet ist, in dem die Sende- und Empfangsspule der Messvorrichtung ausgebildet sind, so dass ein zu messendes Messobjekt während eines Transfers in oder aus der Prozesskammer in den Handlingbereich in einem Abstand von 2 mm bis 50 mm an der Sende- und Empfangsspule des induktiven Sensors vorbeibewegbar ist. Die Größe des Rahmens ist passend für das Durchführen von 200 oder 300 mm breiten Wafern ausgebildet. Auch für größere Panels, welche 500 bis 4500 mm groß sind, ist das Konzept nutzbar. Die Ausgestaltung als Zwischenmodul für Clusteranlagen hat den Vorteil, dass nur sehr wenige Veränderungen an der Anlage vorgenommen werden müssen, da keine elektrischen oder physischen Durchführungen ergänzt werden müssen. Es muss lediglich die Reichweite des Handlers bzw. Transportsystems um die Dicke des Zwischenmoduls erweitert werden. In der ersten Erfindungsvariante ist die Kapsel zur Aufnahme der Sendespule und die Kapsel zur Aufnahme der Empfangsspule in dem Zwischenmodul integriert. In der zweiten Erfindungsvariante sind die Sende- und Empfangsspule jeweils über eine Dichtung oder einen Flansch in dem Zwischenmodul integriert. Bei beiden Varianten ist das zu messende Messobjekt an der Messvorrichtung vorbeibewegbar, ohne dass das Vakuum unterbrochen werden muss. Ein Austausch, eine Wartung und/oder Reparatur der Messvorrichtung ist ebenfalls ohne Vakuumunterbrechung möglich.

In einer weiteren Ausgestaltung der erfindungsgemäßen Messeinrichtungen ist die jeweilige Messvorrichtung in oder an einem Kammerventil, welches die Prozesskammer und den Handlingbereich voneinander trennt, integriert angeordnet. Auch hier misst der Wirbelstromsensor durch eine nichtleitfähige Kapsel hindurch oder durch die direkte Kapselung der Sende- und Empfangsspule. Entweder ist im oder neben dem Kammerventil eine in die Vakuumkammer hineinragende Kapsel integriert ausgebildet oder der jeweils umhüllte Sensorkopf mit der Sende- und Empfangsspule ist in oder neben dem Kammerventil ausgebildet. Die erste Erfindungsvariante hat den Vorteil, dass kein Teil des Sensors im Vakuum positioniert ist. Dies unterstützt die Reinheit von (Ultrahoch-)Vakuumprozessen. Auch erlaubt es, den Sensor auszutauschen, ohne das Vakuum unterbrechen zu müssen. Bei der zweiten Erfindungsvariante sind die wärmeerzeugenden Komponenten, wie der Signalverstärker und/oder die Signalverarbeitungseinheit außerhalb des Vakuums angeordnet und beeinflusst die Messergebnisse nicht negativ.

In einer weiteren anderen Ausgestaltung der erfindungsgemäßen Messvorrichtungen sind mehr als eine Messvorrichtung nach den Ansprüchen 1 bis 9 nebeneinander in einer Reihe ausgebildet. Diese Ausgestaltung ist besonders für Anwendungen in Inlinevakuumbeschichtungsanlagen geeignet, beispielsweise für die Glasbeschichtung mit bis zu 4500 mm Breite. Dafür wird eine Vielzahl der erfindungsgemäßen Messeinrichtungen nebeneinander in Reihen anordnet, um ein zu messendes Messobjekt über dessen gesamte Breite vermessen zu können. Entweder die mehreren Messeinrichtungen sind in einer separaten Messkammer angeordnet. Oder die mehreren Messeinrichtungen sind im Rahmen eines Zwischenmoduls nebeneinander angeordnet. Oder die mehreren Messeinrichtungen sind im und neben einem Kammerventil angeordnet.

In einer Ausgestaltung der erfindungsgemäßen Messvorrichtung ist in unmittelbarer Nähe des induktiven Sensors ein zweiter Sensor, insbesondere ein Temperatursensor angeordnet, wobei mittels des induktiven Sensors Werte eines Schichtwiderstandes des Messobjekts ermittelbar und mittels des Temperatursensors Temperaturwerte des Messobjektes ermittelbar sind, wobei aus den ermittelten Werten des Schichtwiderstandes und den Temperaturwerten des Messobjektes eine Vorhersage über einen Kaltwiderstand des Messobjektes sowie über temperaturunabhängige Schichtdicken des Messobjektes berechenbar sind. Damit lassen sich weitere Prozessparameter, insbesondere die Temperatur, detektieren. Dieser Temperatursensor wird somit genutzt, um eine Vorhersage des Kaltwiderstandes von heiß gemessenen Schichten auf dem Messobjekt durchzuführen bzw. nachfolgend auf die korrekte Metalldicke zurück rechnen zu können.

Zusammenfassend weist die erfindungsgemäße Messvorrichtung folgende Vorteile auf: Die Messung kann berührungslos direkt an einem Prozesswafer, insbesondere an einem produktiven Wafer oder Wafer ähnlichem Substrat als Messobjekt erfolgen. Damit ist eine Echtzeitüberwachung jedes einzelnen Prozesswafers möglich. Damit sind spezielle Testwafer nicht mehr zwingend erforderlich, so dass damit auch Anlagenzeit für Produktionswafer statt Testwafer verwendet werden kann und schlussendlich Betriebskosten reduziert werden können. Auch werden die Materialkosten für Testwafer und den separaten Prüfprozess gespart. Des Weiteren ist es damit möglich, eine direkte Rückkopplung auf den aktuellen Prozess sofort nach der Messung, anstatt nach Stunden oder Tagen von Testwafern zu erhalten. Außerdem kann die Messung ohne Vakuumunterbrechung erfolgen, so dass ebenfalls Prozesszeit für das Abpumpen der Prozesskammern gespart werden kann und ein besseres, weil unmittelbar vorliegendes Messergebnis erreicht werden kann. Es ist ebenfalls möglich, unmittelbar vor und unmittelbar nach einem Schichtabscheidungsprozess zu messen. Dies lässt u. a. Rückschlüsse auf die Qualität, z. B. die (Rest-)Lebensdauer eines Beschichtungstargets zu.

Die vorliegende Erfindung adressiert des Weiteren die Platzverhältnisse innerhalb einer Vakuumkammer, sowie die Anforderung, so wenig wie möglich elektronische Komponenten (Ausgasungen) ins Vakuum zu integrieren.

Damit ist es nun möglich direkt nach der Abscheidung, in einer Vakuumkammer zu messen und wenige Sekunden oder Minuten nach dem Beschichtungsprozess die Metalldicke bzw. den Schichtwiderstand von nicht-transparenten Schichten sowohl auf Test- als auch auf Produktionswafern zu bestimmen. Vorteilhafterweise ist nun kein Ausschleusen von Testwafern und das folgende Messen auf offline Tools (ex-situ) außerhalb des Vakuums mehr notwendig.

Durch die großen Abstände zwischen der/den Sende- und Empfangsspule/n ist ein kollisionsfreier Betrieb auch bei Vibrationen möglich oder die Messung auf zwei-etagigen Handlingsystemen.

Die Erfindung soll nachfolgend an Ausführungsbeispielen näher erläutert werden.
- Fig. 1: Erfindungsgemäße Messvorrichtung gemäß einer ersten Variante;
- Fig. 2: Erfindungsgemäße Messvorrichtung gemäß einer ersten Variante in Verbindung und Anwendung in einer Vakuumkammer;
- Fig. 3: Erfindungsgemäße Messvorrichtung gemäß einer zweiten Variante;
- Fig. 4: Anordnung der erfindungsgemäßen Messvorrichtungen gemäß einer ersten oder zweiten Variante in einem Zwischenmodul;
- Fig. 5: Anordnung bzw. Integration der erfindungsgemäßen Messvorrichtungen an oder in einem Kammerventil;
- Fig. 6: Ausgestaltung der erfindungsgemäßen Messvorrichtungen aus Fig. 4 mit mehreren Messvorrichtungen nebeneinander.

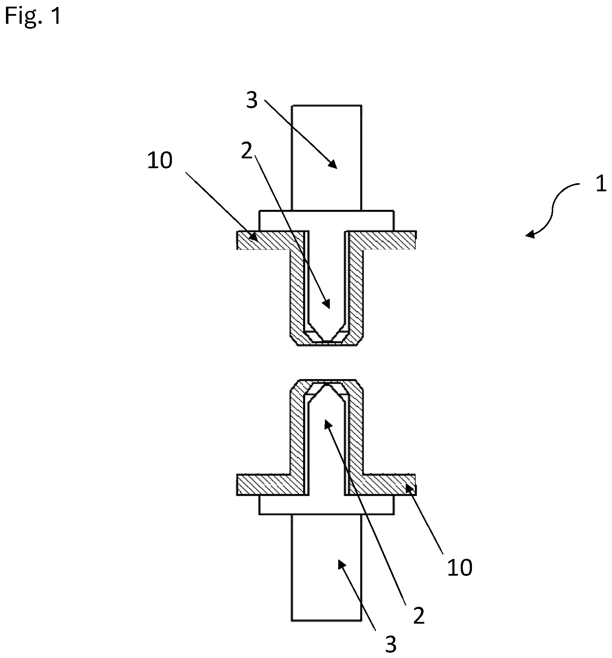

Figur 1 zeigt die erfindungsgemäße Messvorrichtung 1 in einer ersten Variante. Die Messvorrichtung 1 umfasst mindestens einen induktiven Sensor, der mindestens eine Sendespule 2 zum Erzeugen eines elektromagnetischen Wechselfeldes und eine Empfangsspule 2 zum Erfassen einer Impedanzänderung sowie einen Signalverstärker und eine Signalverarbeitungseinheit 3 zur Auswertung der Messsignale aufweist und mindestens eine Kapsel 10, in die die Sende- und/oder Empfangsspule 2 einführbar sind. Die Sende- und Empfangsspule 2 sind jeweils in einer Kapsel 10 angeordnet, wobei die Sende- und Empfangsspule 2 in die Kapsel 10 einsteckbar und auswechselbar ausgebildet sind. Die Messvorrichtung 1 ist in Fig. 1 für eine elektromagnetische Transmissionsmessung ausgebildet, wobei das zu messende Messobjekt zwischen der oben und unten angeordneten Kapsel 10 hindurchbewegt wird oder zwischen den Kapseln 10 statisch vermessen wird. Es ist auch möglich in Reflexion zu messen, wobei sich dann die Sende- bzw. Empfangsspule 2 innerhalb einer Kapsel 10 befinden und von einer Seite das Messobjekt vermessen wird.

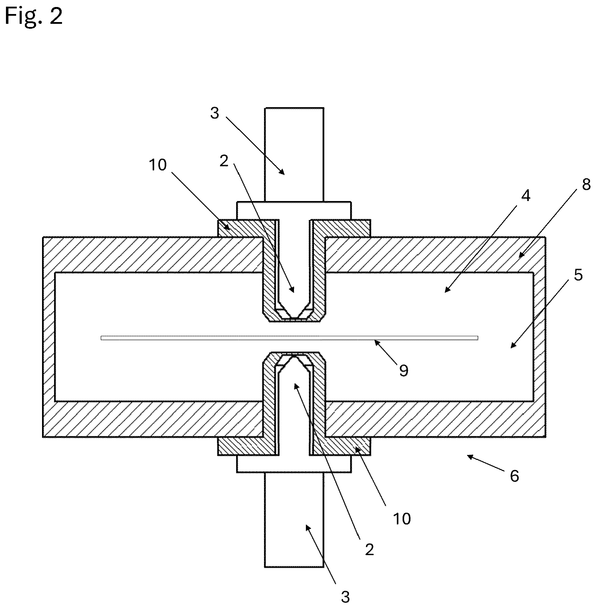

Figur 2 zeigt schematisch die erfindungsgemäße Messvorrichtung 1 in einer ersten Variante eingebaut in einer Vakuumkammer 4. Die Kapseln 10 sind integraler Bestandteil einer Kammerwand 8, die einen Vakuumbereich 5 von einer Atmosphärenseite 6 trennt. Die Spulen 2 als auch die gesamte Verarbeitungselektronik, wie Signalverstärker und/oder die Signalverarbeitungseinheit 3 sind direkt miteinander verbunden und außerhalb des Vakuumbereichs 5 positioniert. Die Kapsel 10 trennt den Sensor vom Vakuum, wobei der Sensor durch das nicht leitfähige Kapselmaterial hindurch misst. Die Kapsel muss mindestens an den Spitzen nichtleitfähig sein, da sonst keine Messung durch die Kapsel möglich ist. Die Ausgestaltung der erfindungsgemäßen Messvorrichtung als Kapselmodul hat den Vorteil, dass kein Teil des Sensors im Vakuum positioniert ist. Dies unterstützt die Reinheit von (Ultrahoch-)Vakuumprozessen. Auch erlaubt es, den Sensor auszutauschen, ohne das Vakuum unterbrechen zu müssen.

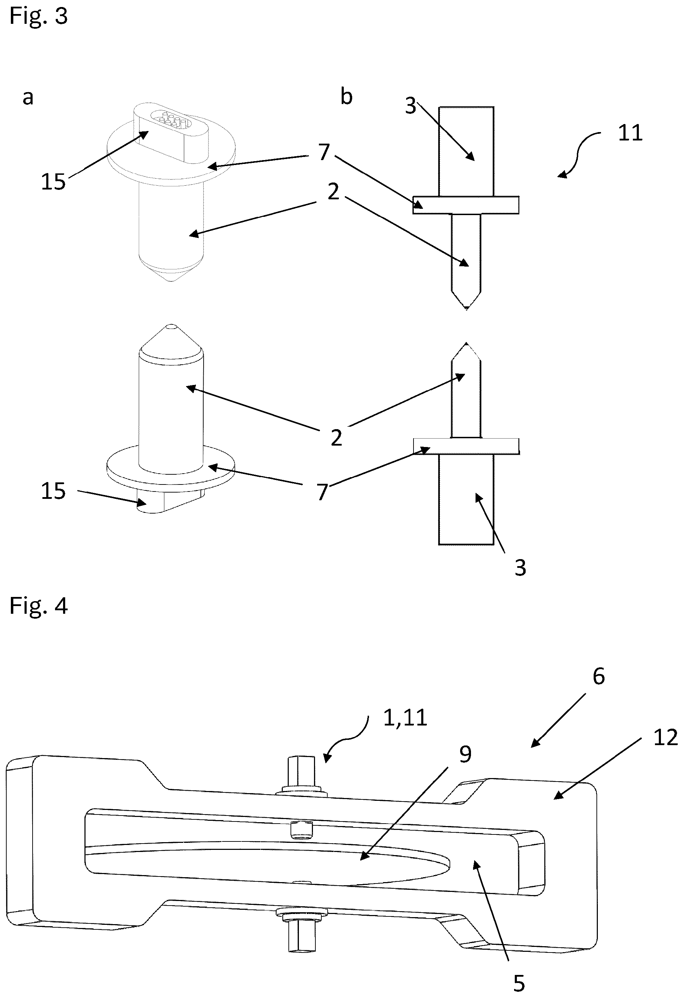

Figur 3 zeigt die erfindungsgemäße Messvorrichtung 11 in einer zweiten Variante - in einer perspektiven Ansicht in Fig. 3a sowie in einer Schnittdarstellung in Fig. 3b. Die Messvorrichtung 11 umfasst mindestens einen induktiven Sensor, der mindestens eine Sendespule 2 zum Erzeugen eines elektromagnetischen Wechselfeldes und eine Empfangsspule 2 zum Erfassen einer Impedanzänderung sowie einen Signalverstärker und/oder eine Signalverarbeitungseinheit 3 zur Auswertung der Messsignale aufweist. Die Sende- und Empfangsspule 2 sind jeweils von einem vakuumtauglichen Material umhüllt ausgebildet, d. h. sie sind von einem nichtleitfähigen und nicht ausgasenden Material eingefasst und bilden einen Sensorkopf. Dieser Sensorkopf 2 ist über einen Flansch oder eine Dichtung 7 in eine Kammerwand von einer Vakuumanlage (nicht gezeigt) innerhalb des Vakuumbereichs der Vakuumkammer angeordnet. Der Signalverstärker und/oder die Signalverarbeitungseinheit 3 sind außerhalb eines Vakuumbereichs (nicht gezeigt) angeordnet. Der Sensorkopf weist eine Anschlussstelle 15 auf mit der die Sende- und Empfangsspule 2 mit dem Signalverstärker und/oder der Signalverarbeitungseinheit 3 auf einer Atmosphärenseite verbunden werden können. In der Schnittdarstellung von Fig. 3b ist die Signalverarbeitungseinheit 3 in Verbindung mit dem Sensorkopf dargestellt. Die perspektive Darstellung in Fig. 3a zeigt die Anschlussstelle 15. Von dem Wirbelstromsensor werden die durch das sich im elektromagnetischen Wechselfeld befindliche Messobjekt hervorgerufenen Signaländerungen detektiert und an die Signalverarbeitungseinheit 3 außerhalb der Messkammer 4 weitergeleitet, wo die Auswertung erfolgt. Die Feldänderungen werden genutzt, um z. B. Rückschlüsse auf Materialeigenschaften einer zu untersuchenden Schicht oder eines Schichtsystems des zu untersuchenden Messobjekts zu ziehen. Das Messobjekt kann z. B. ein Wafer sein. Der Vorteil dieser zweiten Erfindungsvariante 11 ist, dass vermieden wird, wärmeerzeugende Komponenten, wie die Signalverarbeitungseinheit 3, im Vakuum platzieren zu müssen, so dass Platz in der Vakuumkammer eingespart werden kann. Die Messvorrichtung 11 ist in Fig. 3 für eine elektromagnetische Transmissionsmessung ausgebildet, wobei das zu messende Messobjekt zwischen dem oben und unten angeordneten Sensorkopf hindurchbewegt wird oder dazwischen statisch vermessen werden kann. Es ist auch möglich in Reflexion zu messen, wobei sich dann die Sende- und Empfangsspule 2 auf einer Seite das Messobjekt befinden und dieses vermessen wird.

Figur 4 zeigt ein weiteres Ausführungsbeispiel der erfindungsgemäßen Messvorrichtung 1, 11. Die Messvorrichtung 1, 11 ist in einem Zwischenmodul 12 angeordnet bzw. ausgebildet. Ein Zwischenmodul 12 wird als eine Modul verstanden, welches eine Prozesskammer (nicht dargestellt), in der ein zu messendes Messobjekt prozessiert wird, und einen Handlingbereich voneinander trennt. Das Zwischenmodul 12 ist als ein 220 mm bis 4500 mm breiter Rahmen ausgebildet ist, in dem die Sende- und/oder Empfangsspule 2 der Messvorrichtung 1, 11 ausgebildet sind, so dass ein zu messendes Messobjekt 9 während eines Transfers in oder aus der Prozesskammer in den Handlingbereich in einem Abstand von 2 bis 20 mm, bevorzugt in einem Abstand von 2 bis 50 mm an der Sende- und/oder Empfangsspule 2 des induktiven Sensors vorbeibewegbar ist. Die Größe des Rahmens ist passend für das Durchführen von 200 oder 300 mm Wafer oder bis 4500 mmm große Panels ausgebildet. Die Ausgestaltung als Zwischenmodul 12 für Clusteranlagen hat den Vorteil, dass sehr wenige Veränderungen an der Anlage vorgenommen werden müssen, da keine elektrischen oder physischen Durchführungen ergänzt werden müssen. Es muss lediglich die Reichweite des Handlers um die Dicke des Zwischenmoduls 12 erweitert werden. Die Sende- und Empfangsspule 2 können gemäß der ersten Variante der erfindungsgemäßen Messvorrichtung 1 jeweils in einer Kapsel 10 ausgebildet sein, wobei die Kapsel 10 als ein integraler Bestandteil des Zwischenmoduls 12 ausgebildet ist oder die Spulen 2 können gemäß der zweiten Variante der erfindungsgemäßen Messvorrichtung 11 von einem vakuumtauglichen Material umhüllt ausgebildet sein, wobei sie über einen Flansch oder eine Dichtung 7 in dem Zwischenmodul 12 mit dem Signalverstärker und/oder der Signalverarbeitungseinheit 3 auf der Atmosphärenseite verbunden sind.

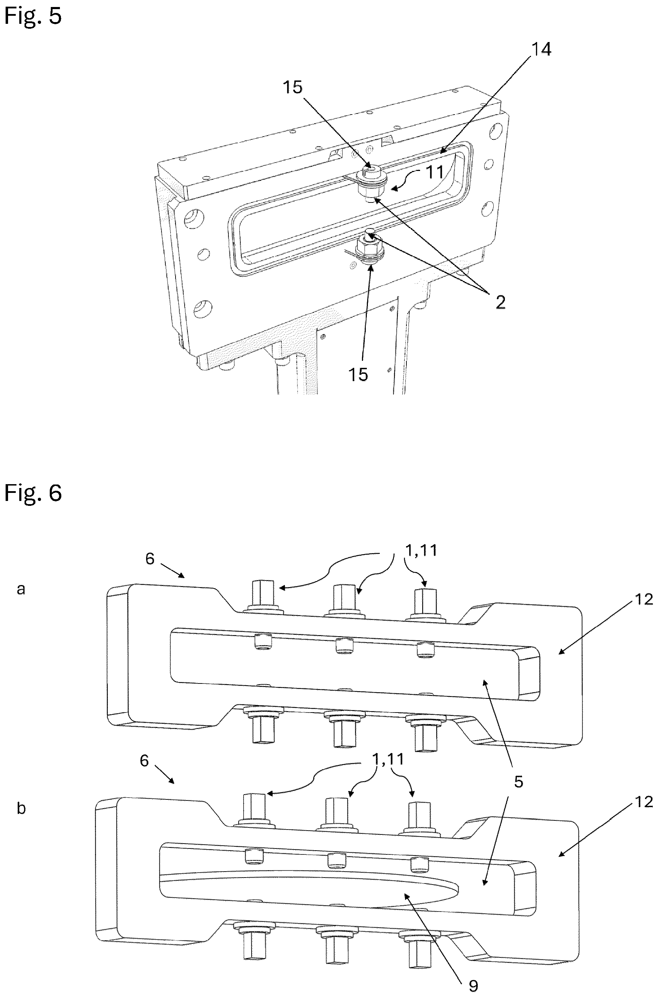

Figur 5 zeigt ein weiteres Ausführungsbeispiel der erfindungsgemäßen Messvorrichtung 11. Die Messvorrichtung 11 ist in einem Kammerventil 14, welches die Prozesskammer (nicht dargestellt) und den Handlingbereich (nicht dargestellt) voneinander trennt, integriert angeordnet. Hierbei werden die von einem vakuumtauglichen Material umhüllten Sende- und Empfangsspule 2 innerhalb des Vakuums positioniert und die Messelektronik 3 außerhalb des Vakuumbereichs positioniert.

Figur 6 zeigt eine Ausgestaltung des Ausführungsbeispiel der erfindungsgemäßen Messvorrichtung 1, 11 aus Figur 4. Für großflächige zu messende Messobjekte 9, wie beispielsweise Wafer oder Glassubstrate oder Panels ist es manchmal notwendig an mehreren unterschiedlichen Stellen zeitgleich messen zu können. Dafür wird eine Vielzahl der erfindungsgemäßen Messeinrichtungen 1, 11 nebeneinander in Reihen anordnet, um ein zu messendes Messobjekt 9 (dargestellt in Fig. 6b) über dessen gesamte Breite vermessen zu können. Figur 6a zeigt die Ausgestaltung dieses Ausführungsbeispiels ohne Messobjekt 9. Entweder die mehreren Messeinrichtungen sind in einer separaten Messkammer angeordnet. Oder, wie in Figur 4 gezeigt, sind die mehreren Messeinrichtungen 1, 11 im Rahmen eines Zwischenmoduls 12 nebeneinander angeordnet. Oder die mehreren Messeinrichtungen 11 sind im und neben einem Kammerventil 14 in Reihen nebeneinander angeordnet.

### Bezugszeichenliste

- 1: Messvorrichtung als Kapsel
- 2: Sende- und/oder Empfangsspule im Sensorkopf, induktiver Sensor
- 3: Signalverstärker und Signalverarbeitungseinheit
- 4: Vakuumkammer
- 5: Vakuumbereich
- 6: Atmosphärenseite
- 7: Flansch oder Dichtung
- 8: Kammerwand
- 9: Zu messendes Messobjekt, z. B. Wafer
- 10: Kapsel
- 11: Messvorrichtung als umhüllte Sende- und Empfangsspule
- 12: Zwischenmodul
- 13: -
- 14: Kammerventil zu einer Prozesskammer
- 15: Anschluss zur Signalverstärkung und Signalverarbeitungseinheit

## Patentansprüche

1. Messvorrichtung (1) zur Charakterisierung eines Messobjektes (9) im Vakuum (5), wobei die Messvorrichtung (1) mindestens einen induktiven Sensor umfasst, der mindestens eine Sendespule (2) zum Erzeugen eines elektromagnetischen Wechselfeldes und eine Empfangsspule (2) zum Erfassen einer Impedanzänderung sowie einen Signalverstärker und/oder eine Signalverarbeitungseinheit (3) zur Auswertung der Messsignale aufweist, **dadurch gekennzeichnet, dass** sowohl die Sende- und Empfangsspule (2) als auch der Signalverstärker und/oder die Signalverarbeitungseinheit (3) außerhalb eines Vakuumbereichs (5) angeordnet sind, wobei die Sende- und Empfangsspule (2) jeweils in eine Kapsel (10) einführbar sind und die Kapseln (10) als ein integraler Bestandteil einer Kammerwand (8) einer Vakuumkammer (4) ausgebildet ist und in das Vakuum (5) hineinragt, wobei die Kammerwand (8) den Vakuumbereich (5) von einer Atmosphärenseite (6) trennt.

2. Messvorrichtung (11) zur Charakterisierung eines Messobjektes (9) im Vakuum (5), wobei die Messvorrichtung (11) mindestens einen induktiven Sensor umfasst, der mindestens eine Sendespule (2) zum Erzeugen eines elektromagnetischen Wechselfeldes und eine Empfangsspule (2) zum Erfassen einer Impedanzänderung sowie einen Signalverstärker und/oder eine Signalverarbeitungseinheit (3) zur Auswertung der Messsignale aufweist, **dadurch gekennzeichnet, dass** die Sende- und/oder Empfangsspule (2) jeweils von einem vakuumtauglichen Material umhüllt ausgebildet sind und innerhalb des Vakuumbereichs (5) angeordnet sind und der Signalverstärker und/oder die Signalverarbeitungseinheit (3) außerhalb eines Vakuumbereichs (5) angeordnet sind, wobei die umhüllte Sende- und Empfangsspule (2) jeweils über einen Flansch oder eine Dichtung (7) über eine Kammerwand (8) einer Vakuumkammer (4) mit dem Signalverstärker und/oder der Signalverarbeitungseinheit (3) auf einer Atmosphärenseite (6) verbunden sind, wobei die Sende- und Empfangsspule (2) einen räumlichen Abstand von 10mm, bevorzugt von bis zu 100mm zueinander aufweisen.

3. Messvorrichtung (1, 11) nach Anspruch 1 oder 2,
**dadurch gekennzeichnet, dass** der induktive Sensor in einer Transmissionsgeometrie ausgebildet ist, wobei die Sendespule (2) oberhalb und die Empfangsspule (2) unterhalb des zu messenden Messobjektes (9) oder umgekehrt ausgebildet ist.

4. Messvorrichtung (1, 11) nach Anspruch 1 oder 2,
**dadurch gekennzeichnet, dass** das zu messende Messobjekt (9) berührungslos vermessbar ist, wobei der induktive Sensor (2) das Messobjekt (9) in elektromagnetischer Transmission während einer Bewegung des zu messenden Messobjekts an dem induktiven Sensor (2) vorbei und/oder statisch auf dem Messobjekt (9) vermisst.

5. Messvorrichtung (1, 11) nach Anspruch 1 oder 2,
**dadurch gekennzeichnet, dass** das zu charakterisierendes Messobjekt (9) in einem Abstand von 2 bis 25 mm, bevorzugt bis 50 mm an den Kapseln (10) oder der umhüllten Sende- und Empfangsspule (2) vorbeiführbar ist.

6. Messvorrichtung (1, 11) nach Anspruch 1 oder 2,
**dadurch gekennzeichnet, dass** die in den Vakuumbereich (5) hineinragenden Kapseln (10) aus einem nichtleitfähigen und nicht ausgasenden Material ausgebildet sind oder die Sende- und Empfangsspule (2) mit einem nichtleitfähigen und nicht ausgasenden Material umhüllt ausgebildet sind.

7. Messvorrichtung (1, 11) nach einem der vorherigen Ansprüche, **dadurch gekennzeichnet, dass** die Messvorrichtung (1, 11) in einer separaten Messkammer angeordnet ist, welche an eine Handlingkammer oder an eine Prozesskammer, in der das zu messende Messobjekt (9) prozessierbar ist, entweder über die Kapseln (10) als Teil der Messvorrichtung (1) oder über einen Flansch oder eine Dichtung (7) anschließbar ist und das zu messende Messobjekt (9) über ein Handlingsystem von der Handlingkammer oder der Prozesskammer in die Messkammer ohne Vakuumunterbrechung transferierbar und dort vermessbar ist.

8. Messvorrichtung (1, 11) nach einem der Ansprüche 1 bis 6, **dadurc hgekennzeichnet**, dass die Messvorrichtung (1, 11) in einem 5 bis 75 mm dicken, vorzugsweise 15 mm dicken Zwischenmodul (12), welches zwischen einer Prozesskammer und einem Handlingbereich angeordnet ist, ausgebildet ist, wobei das Zwischenmodul (12) als ein 220 mm bis 4500 mm breiter Rahmen ausgebildet ist, wobei in dem Rahmen die Sende- und Empfangsspule (2) der Messvorrichtung (1, 11) ausgebildet sind, so dass ein zu messendes Messobjekt (9) während eines Transfers in oder aus der Prozesskammer in den Handlingbereich in einem Abstand von 2 mm bis 100mm an der Sende- und Empfangsspule (2) des induktiven Sensors vorbeibewegbar ist.

9. Messvorrichtung (1, 11) nach einem der Ansprüche 1 bis 6, **dadurch gekennzeichnet, dass** die Messvorrichtung (1, 11) in oder an einem Kammerventil (14), welches eine Prozesskammer und einen Handlingbereich voneinander trennt, integriert angeordnet ist.

10. Messvorrichtung (1, 11) nach einem der Ansprüche 1 bis 9, **dadurch gekennzeichnet, dass** mehr als eine Messvorrichtung (1, 11) nach den Ansprüchen 1 bis 9 nebeneinander in einer Reihe ausgebildet sind.

11. Messvorrichtung (1, 11) nach einem der Ansprüche 1 bis 9, **dadurch gekennzeichnet, dass** in unmittelbarer Nähe des induktiven Sensors ein zweiter Sensor, insbesondere ein Temperatursensor angeordnet ist, wobei mittels des induktiven Sensors Werte eines Schichtwiderstandes des Messobjekts (9) ermittelbar sind und mittels des Temperatursensors Temperaturwerte des Messobjektes (9) ermittelbar sind, wobei aus den ermittelten Werten des Schichtwiderstandes und den Temperaturwerten des Messobjektes (9) eine Vorhersage über einen Kaltwiderstand des Messobjektes (9) getroffen werden kann sowie temperaturunabhängige Schichtdicken des Messobjektes (9) berechenbar sind.
